**Europäisches Patentamt**

**European Patent Office**

**Office européen des brevets**

(11) Numéro de publication: **0 392 892**
**A1**

## DEMANDE DE BREVET EUROPEEN

(21) Numéro de dépôt: **90400755.6**

(22) Date de dépôt: **20.03.90**

(51) Int. Cl.5: **G11C 5/00**

(30) Priorité: **31.03.89 FR 8904301**

(43) Date de publication de la demande:
**17.10.90 Bulletin 90/42**

(84) Etats contractants désignés:
**DE ES GB IT NL**

(71) Demandeur: **GENERAL ELECTRIC CGR S.A.**
**100, rue Camille-Desmoulins**
**F-92130 Issy les Moulineaux(FR)**

(72) Inventeur: **Bodelet, Philippe**
**Cabinet Ballot-Schmit, 7, rue Le Sueur**

**F-75116 Paris(FR)**
Inventeur: **Gannat, Daniel**
**Cabinet Ballot-Schmit, 7, rue Le Sueur**
**F-75116 Paris(FR)**
Inventeur: **Pascal, Philippe**
**Cabinet Ballot-Schmit, 7, rue Le Sueur**
**F-75116 Paris(FR)**

(74) Mandataire: **Schmit, Christian Norbert Marie**
**et al**
**Cabinet Ballot-Schmit 7, rue Le Sueur**
**F-75116 Paris(FR)**

(54) **Module mémoire compact pour carte de mémoire de données d'un processeur d'images.**

(57) On réalise un module (5) mémoire compact en implantant de part et d'autre d'une plaquette (7) en circuit imprimé de forme rectangulaire, des circuits intégrés élémentaires de mémoires. Ces circuits intégrés élémentaires sont rectangulaires. Lors de l'implantation les grands côtés des circuits intégrés élémentaires sont parallèles aux grands côtés de la plaquette. La plaquette est ultérieurement embrochée (12) sur chant sur une carte mère (1) du processeur d'images. On montre que cette manière de faire permet en outre d'implanter sur le module des amplificateurs (18-21) de commande de cette mémoire, ce qui fait encore gagner de la place. On peut réaliser ainsi un bloc de 16 Mega octets sur une surface de carte mère de 240 cm2 seulement. Les plaquettes ne mesurent que 15mm de haut afin de respecter la norme VME.

FIG_1

EP 0 392 892 A1

La présente invention a pour objet un module mémoire compact pour une carte de mémoire de données d'un processeur d'images. Elle trouve son application plus particulièrement dans le domaine médical où des processeurs d'images sont utilisés pour visualiser à des fins de diagnostic des images acquises selon des protocoles de radiologies, de RMN, de gammagraphie ou d'ultrasons. L'invention peut néanmoins trouver son application dans d'autres domaines où, comme en imagerie médicale, on dispose d'images de grande taille (par exemple 1024 points par 1024 points) et stockées dans des mémoires vives.

Un processeur d'images est un circuit de type électronique relié à un moniteur de visualisation. Il permet d'affecter à chaque élément d'image, ou pixel, du moniteur une information lumineuse (et quelquefois même en couleur) représentative d'une information physique stockée dans une cellule mémoire d'une mémoire d'images correspondante. Le processeur d'images comporte donc un décodeur d'adresses pour pouvoir désigner les unes après les autres les cellules mémoires d'une mémoire d'images à lire, un circuit de lecture pour lire le contenu des cellules mémoires et, bien entendu, la mémoire d'images elle même. La mémoire est normalement une mémoire de type dit dynamique dont le temps de cycle virtuel est de l'ordre de 40 nanosecondes. Ceci signifie qu'on peut, dans la pratique, lire actuellement une telle mémoire avec une horloge fonctionnant à fréquence de 25 Megahertz. Les valeurs des informations physiques stockées dans les cellules mémoires sont couramment codées sur huit bits, éventuellement neuf en y incluant un bit de parité. En organisant les circuits de lecture écriture de la mémoire d'une manière parallèle, on peut arriver, à lire plusieurs octets plutôt que de ne lire qu'un octet à chaque cycle d'accès à la mémoire. On obtient donc dans ces conditions des débits d'informations de l'ordre de 120 Mega octets par seconde.

Une mémoire d'images est normalement implantée sur une carte électronique dite ici carte mère. Cette carte mère est destiné à être installée dans une armoire électronique générale. Dans le but de souscrire à des normes, de type VME, imposées, il est admis qu'une telle carte mère doit avoir une épaisseur inférieure sur carte inférieure à 15 mm, y compris les composants qui y sont implantés. L'écart nominal toléré entre cartes est de 20, 32mm. On peut bien entendu réaliser des processeurs d'images avec des cartes mères qui seraient plus épaisses mais les produits ainsi fabriqués, ne seraient pas compatibles avec les armoires électroniques dans lesquels ils seraient destinés à être installés. Ils présenteraient par ailleurs une fiabilité moindre.

La mémoire d'images d'un processeur d'images comporte des circuits intégrés électroniques élémentaires rassemblant les cellules mémoires. Les progrès de la miniaturisation d'une part, et de l'aptitude à la plus grande intégration d'autre part, ont ainsi conduit à réaliser en standard divers types de boîtier dans lesquels ces circuits intégrés électroniques élémentaires sont livrés. Un premier boîtier a 18 broches de connexion, il comporte 256 K cellules mémoires (K = 1024), est parallélépipèdique, et a une largeur d'environ 10mm et une longueur d'environ 15mm. Un boîtier plus récent comporte 256 K X 4 cellules mémoires , possède 20 broches de connexion et mesure environ 10mm de largeur pour environ 20mm de long. Les épaisseurs de ces deux boîtiers sont sensiblement comparables. Un processeur d'images comporte normalement de quoi contenir en mémoire vive plusieurs images (16 images dans un exemple). Si les images sont définies par 1024 X 1024 points, et si en chaque point on autorise la définition d'un niveau de luminosité sur huit bits, on est contraint à réserver en mémoire huit Mega bits ou un Mega octets par image.

Compte tenu de ce que chaque boîtier moderne ne peut contenir ainsi qu'un Mega bits, on est conduit à devoir implanter sur la carte mère 128 boîtiers. Compte tenu de la surface de chaque boîtier, ce nombre de boîtier est trop important. Il entraîne la construction de cartes mères bien trop grandes. Pour résoudre cette difficulté, il est connu de réaliser des plaquettes intermédiaires de circuit imprimés sur lesquelles les circuits intégrés élémentaires sont assemblés côte à côte. La plaquette étant ultérieurement dressée sur chant au moment de sa connexion à la carte mère. Compte tenu de la hauteur disponible entre cartes dans une même armoire électronique cette solution n'est cependant envisageable que pour les boîtiers anciens : c'est-à-dire pour les boîtiers ne comportant qu'un nombre limité de cellules mémoires. Pour les boîtiers modernes, la longueur de 20mm du grand côté orientée dans le sens de la largeur de la plaquette ne permet pas de respecter le standard de 20,32mm d'écart. Aussi, à été proposé d'embrocher les plaquettes en biais dans la carte mère. L'inclinaison des plaquettes permet alors de respecter la largeur standard imposée entre deux cartes.

Le circuit de commande des cellules mémoires d'une mémoire nécessite, dans son principe, des amplificateurs de courant débitant dans des lignes de commande auxquelles sont raccordées les boîtiers mémoires. Ces amplificateurs de commande doivent avoir une sortance compatible avec la somme des entrances des boîtiers mémoires qui leurs sont raccordés par une même ligne de commande. Comme on l'a indiqué précédemment un processeur d'images doit pouvoir gérer un nombre relativement important d'images à représenter. En conséquence, il doit comporter un nombre important de plaquettes munies de leurs boîtiers mémoires assemblés et le cas échéant de leur connecteur incliné de connexion. Compte tenu de la sortance limitée des amplificateurs de commande la carte mère du processeur d'images doit en comporter plusieurs. En conséquence, le dessin de cette carte mère doit être décidé à chaque fois que, pour une application particulière, le nombre des images à mettre en oeuvre est différent. En effet, l'implantation des amplificateurs de commande sur la carte mère vient s'imbriquer dans des connexions d'adressage des cellules mémoires des plaquettes. En définitive il complique la réalisation de ces processeurs d'images.

L'invention a pour objet de remédier à ces inconvénients en proposant un module de type universel, qui souscrit à la fois aux normes de compatibilité, qui prenne en compte les boîtiers modernes (les plus performants), et qui résolve d'une manière systématique la difficulté d'implantation des amplificateurs de commande des cellules mémoires.

Dans l'invention, on utilise également des plaquettes embrochées sur chant dans la carte mère. Ces plaquettes sont également munies de circuits intégrés électroniques élémentaires. Mais ces circuits ont particularité d'être assemblés sur la plaquette avec leur grand côté (les 20mm) orientés parallèlement au grand côté de la plaquette rectangulaire. Normalement cette solution n'est pas retenue parce qu'elle conduit, pour réaliser une plaquette avec huit boîtiers, à disposer d'une plaquette trop longue. Avec une plaquette longue la densité utile des broches de la plaquette connectables à la carte mère est faible. Cette densité faible est en définitive synonyme d'une perte de place, d'une moins grande compacité, d'une moins grande compatibilité, et donc d'une moins grande fiabilité.

Dans l'invention, en ayant choisi cependant cette orientation, on a alors eu l'idée d'implanter les boîtiers électroniques de part et d'autre de la plaquette. Compte tenu des longueurs des boîtiers, on s'est rendu compte que la plaquette ainsi agrémentée présentait alors des espaces libres de part et d'autre des alignements des boîtiers. On a alors judicieusement utilisé ces espaces libres pour implanter, sur la plaquette elle même cette fois, les amplificateurs de commande nécessaires à la commande de l'accès aux cellules mémoires qui se trouvent contenus dans les boîtiers électroniques assemblés sur cette plaquette. Dans ces conditions on réalise un module, la plaquette, universel, indépendant, et qu'on peut embrocher au fur et à mesure des besoins sur la carte mère du processeur d'images, sans avoir par ailleurs à redéfinir, à cause des amplificateurs de commande, le schéma d'implantation de cette carte mère.

L'invention a donc pour objet un module mémoire compact pour carte mère d'un processeur d'images, ce module comportant au moins une plaquette rectangulaire de connexion, du type circuit imprimé, sur laquelle sont assemblés des circuits intégrés électroniques élémentaires de mémoire, ces circuits intégrés étant de forme rectangulaire, ce module étant destiné à être embroché par son grand côté sensiblement perpendiculairement à cette carte mère, caractérisé en ce que ces circuits intégrés sont placés de part et d'autre sur cette plaquette, de telle façon que leurs grands côtés soient parallèles au grand côté de cette plaquette, et de manière à ce que la plaquette porte en plus un jeu d'amplificateurs de courant nécessaires pour la commande des cellules mémoires contenues dans les circuits intégrés portés par la plaquette.

L'invention sera mieux comprise à la lecture de la description qui suit et à l'examen des figures qui l'accompagnent. Celles-ci ne sont données qu'à titre indicatif et nullement limitatif de l'invention. Les figures montrent :

- figure 1 : la représentation en perspective d'un module mémoire selon l'invention, monté sur une carte mère;

- figure 2 : une vue de dessus de plusieurs modules mémoires selon l'invention accolés les uns aux autres.

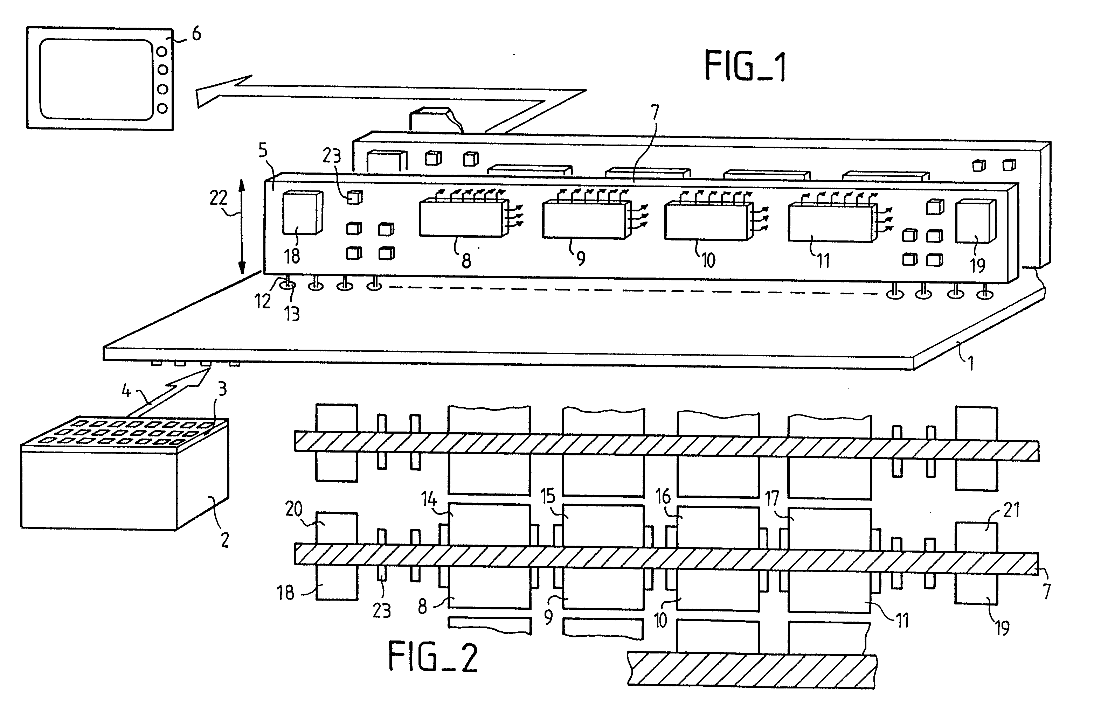

La figure 1 montre en perspective une carte mère 1 pour un processeur d'images. Ce processeur d'images comporte classiquement un décodeur d'adresses 2. Ce décodeur peut être piloté par un programme lancé depuis un clavier 3. Ce décodeur est en relation par un bus 4 avec un ou plusieurs modules mémoires compacts tels que le module mémoire 5. Le processeur d'images peut comporter d'autres circuits, notamment pour le traitement des images en vue de leurs transformations. Il est généralement en relation avec un moniteur 6 de visualisation. Le module mémoire de l'invention comporte au moins une plaquette rectangulaire 7, du type circuit imprimé, sur laquelle sont assemblés des circuits intégrés électroniques élémentaires de mémoire, par exemple sur une première face, les circuits 8 à 11. La plaquette 7 est dressée sur chant sur un des ses grands côtés. La plaquette 7 est destinée à être embrochée perpendiculairement à la carte mère 1 par ses broches de connexion telles que 12 dans des trous métallisés de contact 13. Quand l'embrochage est effectué les broches sont soudées aux trous. Dans un exemple préféré le module de l'invention comporte 45 broches utiles telles que la broche 12. Ces broches sont espacées du pas de 2,54mm de sorte que la plaquette 7 à une longueur d'environ 140mm.

Les circuits intégrés électroniques 8 à 11 sont de préférence du type de ceux livrés dans des boîtiers modernes dont la largeur est de l'ordre de 10mm et dont la longueur est de l'ordre de 20mm. Dans l'invention, ces boîtiers ont la particularité d'être assemblés sur la plaquette 7 de manière à ce que leur grand côté soit orienté parallèlement au grand côté de la plaquette. La figure 2 montre en vue de dessus que la plaquette 7 porte sur son autre face un autre ensemble de quatre autres boîtiers modernes numérotés 14 à 17 placés, en vis à vis des quatre premiers. Pour les connexions des broches de ces circuits intégrés la plaquette 7 de circuit imprimé peut être une plaquette de circuit imprimé double face. De préférence elle comporte plutôt un réseau de connexions en couche interne, intermédiaire entre les deux faces externes de cette plaquette. Les connexions en couche interne aboutissent d'une part aux broches telles que 12 de la plaquette et d'autre part à des métallisations correspondantes des circuits intégrés qui lui sont fixés. La réalisation de la plaquette 7 nécessite la réalisation en multicouche du réseau en couche interne. Dans un exemple le multicouche a huit couches. La réalisation nécessite aussi le perçage et la métallisation des trous de fixation et de connexion des circuits intégrés sur les faces de cette plaquette, et la mise en place de ces circuits intégrés. Pour éviter les courts-circuits les trous correspondants à une face sont décalés par rapport aux trous de l'autre face. Les circuits 8 à 11 et 14 à 17 sont assemblés avec une technologie de montage en surface. Cette technologie permet de mettre des boîtiers sur les deux faces. Dans cette technologie les boîtiers sont préalablement collés en position sur la plaquette. La plaquette ainsi composée est ensuite passée dans un four. Un étamage préalable de métallisations provoque la soudure automatique des bornes des boîtiers.

La liaison des circuits intégrés à la carte mère imposant un nombre de broches telles que 12 important, la longueur de la plaquette 7 est telle qu'il reste de la place de chaque côté des alignements des circuits intégrés, à droite et à gauche et sur chacune des faces de la plaquette, pour pouvoir y implanter des amplificateurs de commande tels que 18 à 21. De préférence ces amplificateurs de commandes sont placés sur les bords des plaquettes. De cette manière le routage est simplifié : le multicouche doit comporter moins de couche et sa classe de gravure est moins exigeante. En plus, l'adaptation en impédance des lignes de commande devient possible au début de chaque ligne il n'y a qu'une résistance à connecter en série au lieu de deux à chacune des deux extrémités de cette ligne : dans le cas contraire. Intermédiaire entre ces amplificateurs de commande et les alignements des circuits intégrés électroniques élémentaires, on a donc placé des résistances en série avec ces amplificateurs de commande. De cette manière on amortit la transmission à partir de ces amplificateurs de commande des impulsions de commande : on évite une suroscillation du signal au moment de la transmission. De préférence, les amplificateurs de commande sont du type à résistances externes : avec des résistances externes, ces amplificateurs sont plus petits et ils deviennent logeables sur la surface de la plaquette 7. Compte tenu des dimensions évoquées jusqu'ici le module 5 présente, au-dessus du plan de la carte mère, une hauteur 22 de l'ordre de 15mm qui permet de souscrire sans difficulté aux impératifs imposés par les normes. Dans ces conditions le processeur d'images de l'invention devient compatible avec les matériels déjà existants.

On remarque que le choix d'orienter les boîtiers des circuits intégrés électroniques élémentaires horizontalement par rapport à la carte mère, et donc sensiblement parallèlement à la plaquette 7, en même temps que leur répartition de part et d'autre des faces de cette plaquette permet de réaliser un composant dont la longueur n'est pas supérieure à celle qui résulte du produit de l'espacement normalisé entre des broches par le nombre de broches utiles pour ce module. Dans le cas contraire, en particulier si les circuits intégrés n'avaient pas été implantés sur les deux faces, on aurait été conduit à réaliser un module trop long qui aurait nui à la compacité, et donc à la fiabilité et à la compatibilité du processeur réalisé.

Les boîtiers modernes de circuits-intégrés électroniques disponibles dans le commerce ont une capacité de 1 Mega bits utile organisée selon divers standards, de préférence organisée avec une capacité de 256 K mots de 4 bits. Aussi, avec huit circuits intégrés élémentaires par plaquette, donc avec 4 X 8 = 32 partitions de 256 K bits par plaquette, on a organisé l'accès au module de manière à constituer 256 K mots de 32 bits. Quand on adresse un ce ces mots, on lit 32 bits. Ceci permet d'augmenter dans certaines applications le débit des accès. Dans la pratique, les luminosités des pixels sont codées sur quelques bits, par exemple, huit bits. En définitive, en agissant ainsi on a accès non pas à un mot de 32 bits qui représenterait un seul pixel dont la luminosité serait codée sur 32 bits, mais en fait à seize pixels associés dont les luminosités sont codées chacune sur deux bits comme d'habitude.

L'association de huit plaquettes permet d'obtenir seize pixels de seize bits utilisés en 32 pixels de huit bits : chaque module contenant un huitième de l'image. Evidemment, chaque module est concerné par huit images. En pratique, ces huit partitions d'une même image correspondent à des colonnes. Ceci permet de produire un signal vidéo, qui résulte de la scrutation en parallèle (mais avec un léger décalage dans le temps) des huit partitions à un rythme 24 fois plus rapide que celui auquel on peut accéder à chaque mémoire. On pourrait montrer que ce mode de traitement permet d'obtenir une mémoire très performante dans les applications VME, et d'obtenir une bande passante de 120 Mega octets par seconde dans des applications de traitement d'image. On remarquera par ailleurs que le fait de travailler dans certaines applications, en particulier de traitement, avec des mots de 32 bits permet de n'utiliser que 18 bits d'adresses sur les vingt normalement disponibles, pour accéder au 256 K mots de 32 bits contenus dans un module. Les deux bits d'adressages de poids faibles sont alors utilisés, après décodage, pour constituer des instructions de lecture ou d'écriture en octets. Bien entendu, le module mémoire de l'invention est aussi susceptible de fonctionner en mots de huit bits. Auquel cas le module qui contient 1 Mega octets peut être accédé, avec un adressage de 20 bits, d'une manière classique.

## Revendications

1. Module (5) mémoire compact pour carte de mémoire de données dite carte mère (1) d'un processeur (1-6) d'images, ce module comportant au moins une plaquette (7) rectangulaire de connexion, du type circuit imprimé, sur laquelle sont assemblés des circuits intégrés électroniques élémentaires de mémoire, (8-11, 14-17) ces circuits intégrés étant de forme rectangulaire, ce module étant destiné à être embroché (12) par son grand côté sensiblement perpendiculairement à cette carte mère, caractérisé en ce que ces circuits intégrés sont placés de part et d'autre sur cette plaquette, de telle façon que leurs grands côtés soient parallèles au grand côté de cette plaquette, et de manière à ce que la plaquette porte en plus un jeu d'amplificateurs (18-21) de courant nécessaires pour la commande des cellules mémoires contenues dans les circuits intégrés portés par la plaquette.

2. Module selon la revendication 1 caractérisé en ce que la hauteur des plaquettes au-dessus de la carte mère est de l'ordre de 15mm.

3. Module selon la revendication 1 ou la revendication 2, caractérisé en ce que les jeux d'amplificateurs de commande sont placés de part et d'autre d'alignements de ces circuits intégrés.

4. Module selon l'une quelconque des revendications 1 à 3, caractérisé en ce que les amplificateurs de commande sont du type à résistances externes (23).

5. Module selon l'une quelconque des revendications 1 à 4, caractérisé en ce qu'il comporte quatre amplificateurs de commande.

6. Module selon l'une quelconque des revendications 1 à 5 caractérisé en ce que les circuits intégrés élémentaires sont du type dont l'organisation mémoire est à accès quadruple.

FIG_1

FIG_2

EP 0 392 892 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | FUJITSU SCIENTIFIC & TECHNICAL JOURNAL, vol. 21, no. 4, septembre 1985, pages 452-460, Kawasaki, JP; M. TAKAMURA et al.: "High-density packaging of main storage" * En entier * | 1 | G 11 C   5/00 |
| A | IDEM | 2 | |
| Y | EP-A-0 165 692  (FUJITSU) * Page 9, ligne 31 - page 10, ligne 17; figure 5 * | 1 | |
| A | EP-A-0 135 821  (WANG LABORATORIES) * Page 4, ligne 21 - page 5, ligne 7; figure 2 * | 1,2 | |
| A | GB-A-2 170 657  (STC PLC) * En entier * | 1 | |
| A | DATABUS, no. 4, avril 1984, pages 44-45, Deventer, NL; "2 Mbit op 3 cm2" * En entier * | 1,2,6 | **DOMAINES TECHNIQUES RECHERCHES (Int. Cl.5)** G 11 C   5/00 G 11 C  11/40 G 11 C  11/41 |

Le présent rapport a été établi pour toutes les revendications

| Lieu de la recherche | Date d'achèvement de la recherche | Examinateur |
|---|---|---|
| LA HAYE | 07-08-1990 | DEGRAEVE L.W.G. |